# EUROPEAN PATENT APPLICATION

(11) **EP 2 916 172 A1**
(43) Date of publication of application: **09.09.2015**
(21) Application number: 14001317.8
(22) Date of filing: 10.04.2014
(51) Int. Cl.: G03F 7/20

(54) **Improvements in the manufacture of craft stamps**

(30) Priority: 13.02.2014 US 201414179634
(71) Applicant: Chemence, Inc., Alpharetta, GA 30005 (US)
(72) Inventor: Maneira, John P., Alpharetta, GA 30022 (US)
(74) Representative: Morgan, David James

(57) **Abstract**

An indexing image for craft stamps that is opaque to the eye but transparent to UV light is produced by printing a wavelength-specific solvent-based ink on the stamp substrate. This eliminates the step of printing a separate adhesive-backed indexing image sheet and applying it to the substrate.

## Description

This invention is in the field of printing, more specifically in the field of manufacturing craft stamps, and still more specifically in the field of making craft stamp pads using photopolymer plates.

Photopolymer craft stamps of a certain theme or style are typically imaged in photopolymer on a clear substrate using standard techniques -- a UV-opaque mask image sheet being placed on top of the substrate and a UV-opaque relief image sheet bellow - and they are sold right on the substrate. An additional thermally-printed indexing image sheet is manually glued to the substrate so that the consumer can see what the stamp images will look like. The consumer peels a particular stamp off the substrate and sticks it to a clear acrylic block for use, then puts it back on the substrate when done.

The present invention does away with the additional indexing image sheet by printing the indexing image in UV-transparent but optically opaque ink right on the substrate. Because it is UV transparent, this visible image does not interfere with development of the mask image in the photopolymer.

According to one aspect of the present invention we provide a craft stamp indexing image, in which an actinic radiation-transmitting substrate and ink are applied to the substrate, the ink being of the type that does not transmit visible wavelengths of light but does transmit radiation that cures photopolymers.

Preferably said ink is solvent-based and said substrate is compatible with said ink.

Suitably said substrate comprises a plastic taken from the list of (a) vinyl-based plastic and (b) polyester.

Conveniently said vinyl-based plastic is taken from the list of polyvinylethylene and polyvinyl chloride.

Preferably said ink comprises visible light blockers.

Suitably said visible wavelengths are between about 390 nm and 700 nm.

According to another aspect of the present invention we provide a method for making a craft stamp, the method comprising the steps of:
(a) printing masking images on a masking film ;
(b) printing stamp relief images on a relief image film;
(c) printing an indexing image on a compatible substrate;
(d) placing the relief image film on the bottom glass of a UV exposure unit;
(e) optionally covering the relief image film with a protective film;
(f) optionally pulling a vacuum under the relief image film;
(g) casting a layer of liquid photopolymer on top of the relief image film;
(h) placing the substrate in contact with the upper surface of the liquid photopolymer layer;
(i) placing the masking film on top of the substrate;
(j) lowering the lid on the UV exposure unit and optionally pulling a vacuum on the masking film and substrate;
(k) shining polymerizing radiation through the masking film for an amount of time suitable to form polymerized floor images of a desired thickness in the liquid photopolymer;
(l) shining polymerizing radiation through the relief images for an amount of time suitable to form polymerized relief images in the liquid photopolymer between the polymerized floor images and the relief images;
(m) removing the above materials from the exposure unit;
(n) removing the masking film and the relief image film from the materials; and
(o) cleaning the polymerized material and substrate.

Preferably step (c) involves printing an indexing image with an inkjet printer using a UV-transmitting and visible light-opaque ink on the substrate, the substrate comprising vinyl-based polymeric material.

Suitably step (c) involves printing an indexing image with an inkjet printer using a UV-transmitting and visible light-opaque ink on the substrate, the substrate comprising polyvinylethylene.

Conveniently step (c) involves printing an indexing image with an inkjet printer using a UV-transmitting and visible light-opaque ink on the substrate, the substrate comprising polyvinyl chloride.

Preferably step (c) involves printing an indexing image with an inkjet printer using a UV-transmitting and visible light-opaque ink on the substrate, the substrate comprising polyester.

Suitably an actinic radiation-transmitting substrate comprises solvent ink-printable polymers with ink applied to the substrate, the ink being solvent-based and opaque to visible wavelengths of light and able to transmit radiation that cures photopolymers.

Embodiments of the invention will now be particularly described with reference to the accompanying drawings in which:
Figure 1 is a cross-sectional illustration of a prior art method of using a liquid photopolymer to make a craft stamp I-plate.
Figure 2 is a perspective illustration of the separate layers produced in the prior art method of making a sheet of craft stamps.
Figure 3 is a perspective illustration of making a print using a stamp made according to the above method.
Figure 4 is a perspective illustration of the layers of a sheet of craft stamps made in accordance with the present invention and
Figure 5 is a perspective illustration of the separated layers of a sheet of craft stamps produced after the exposure shown in Fig. 4 is fully cured and post-treated.

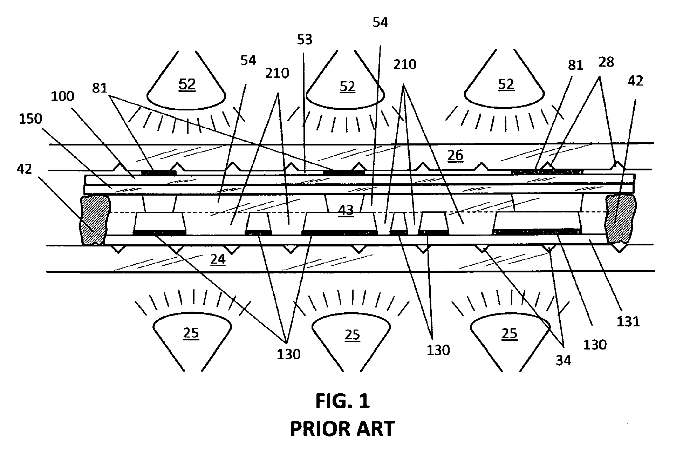

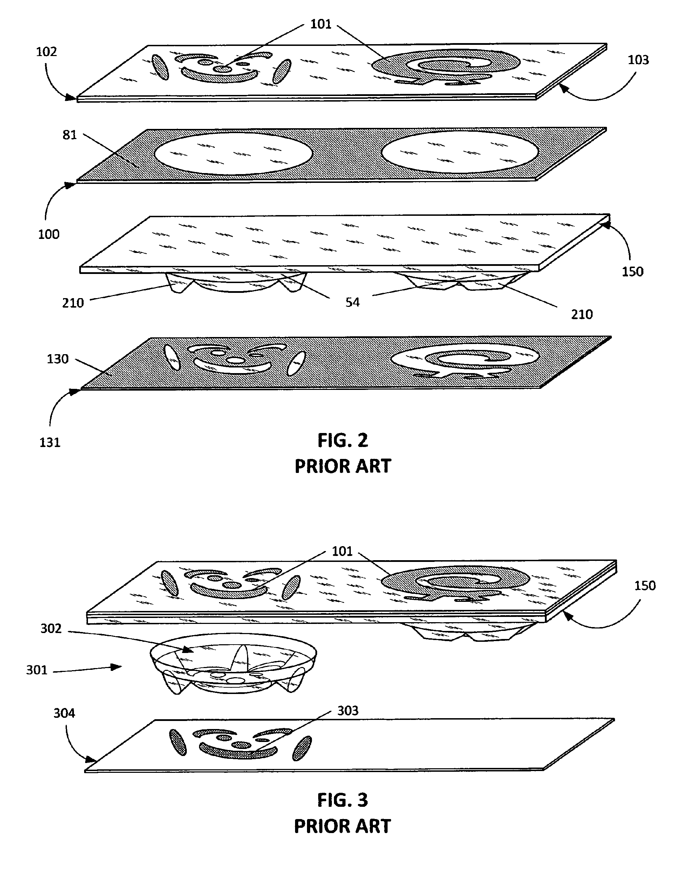

A cluster of craft stamps of a certain theme or style are typically produced together on one sheet of substrate from a photopolymeric procedure. The stamps have a clear, thin backing sheet upon which an island plate (or "I-plate") has been developed. Each stamp is a relief image supported by a island image floor which acts as a webbing to hold together thin elements of the relief. Once developed, the cluster of stamps are sold right on the substrate. Referring now to the drawings, which are not to scale, and in which like reference characters refer to like elements among the drawings, Figure 1 is a cross-sectional illustration of a prior art method for making an I-plate suitable for a cluster of stamps. The steps involved are as follows:
(a) Print the stamp floor (masking) images 81 on a clear masking film 100;
(b) Print the stamp relief images 130 on a clear relief image film 131;
(c) Print the stamp images 101 on a clear indexing image sheet 102 (see Fig. 2);
(d) Apply a layer of adhesive (not visible in this view) to the underside of the indexing image sheet 102;
(e) Place the relief image film 131 with the relief images 130 on the bottom glass 24 of the UV exposure unit (preferably, but not essentially, with the image side facing up);
(f) Optionally cover the relief image film 131 with a protective cover film (not shown);
(g) Optionally pull a vacuum in lower vacuum grooves 34 to remove air from under image film 131;
(h) Cast a layer of liquid photopolymer 43 adjacent to the relief image film 131 (employing dams 42 if necessary);
(i) Place a clear substrate 150 in contact with the upper surface of the liquid photopolymer layer 43;
(j) Place the printed masking film 100 on top of the clear substrate 150 (registering the mask image properly with respect to the relief image);
(k) Optionally pull a vacuum in upper vacuum grooves 28 to remove air from between upper glass 26, masking film 100, and substrate 150;
(l) Shine polymerizing light 52 through the masking film 100 for an amount of time suitable to form polymerized floor images 54 of a desired thickness in the liquid photopolymer;
(m) Shine polymerizing light 25 through the relief images 130 for an amount of time suitable to form polymerized relief images 210 in the liquid photopolymer between the polymerized floor images 54 and the relief images 130;
(n) (Not shown) Remove the above layers from the exposure unit and perform post-exposure treatment; and
(o) (Not shown) Glue the indexing image sheet 102 to the clear substrate 150 (registering it properly with respect to the relief image).

Figure 2 is a perspective illustration of the separated layers of a sheet of craft stamps produced after the exposure shown in Fig. 1 is fully cured and post-treated. The masking film 100 with its masking image 81, and the relief film 131 with its relief images 130, produce the stamp floor images 54 and the stamp relief images 210 during exposure to UV light. They are removed from the substrate 150 and the stamp relief images 210, respectively, and are discarded or reused. Fig. 2 also shows the clear indexing image sheet 102 that is typically thermally printed with the black index images 101 that are congruent to the ink image that will be printed by the stamp. This has an adhesive layer 103 applied to its underside so that it can be affixed to the clear top 104 of the stamp substrate 150. This is a labor-intensive step because the sticky image sheet 102 must be applied manually in exact registration with the stamp relief images 210 underneath.

Figure 3 is a perspective illustration of making an ink print 300 using a stamp 301 made according to the prior art method. The black indexing images 101 visible on top of the clear substrate 150 show the user what will be printed with a particular stamp. The stamp 301, which has a tacky upper surface 302 after the photopolymer is cured, has been peeled off of the substrate 150, temporarily applied to a clear plastic stamp tool (not shown), inked, and used to make an ink image 303 on a sheet of, e.g., paper 304.

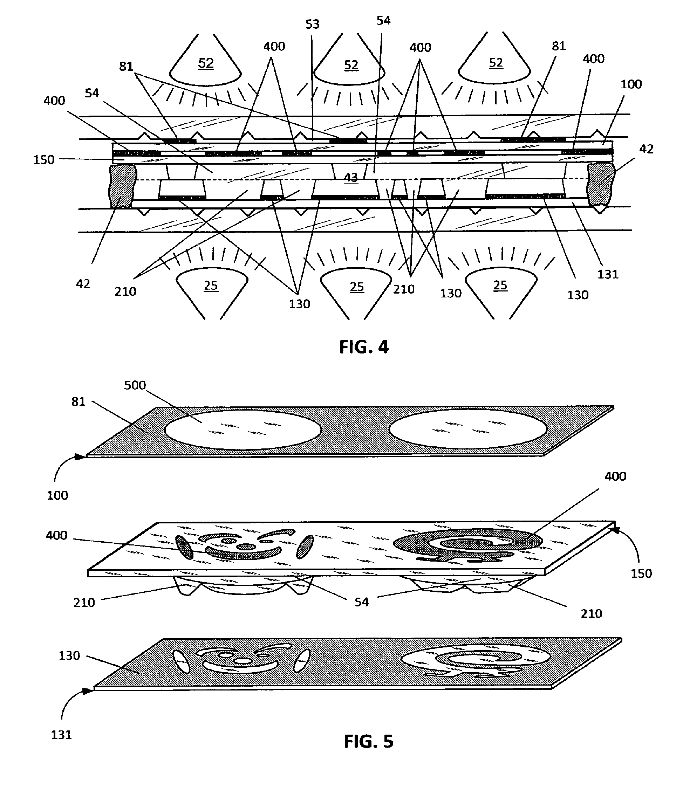

Figure 4 is a perspective illustration of the layers of a sheet of craft stamps made in accordance with the present invention. It is very similar to Fig. 1 except that indexing images 400 have been inkjet printed on the substrate 150 before the substrate 150 was placed on top of the photopolymer layer 43. Note that the indexing images 400 exactly match the shape of the bottoms of the polymeric stamp relief images 210. This is more fully described in the following Fig. 5. The steps in this process are:
(a) Print the masking images 81 on a masking film 100;
(b) Print the stamp relief images 130 on a relief image film 131;
(c) Print an indexing image 400 on a substrate 150;
(d) Place the relief image film 131 on the bottom glass 24 of the UV exposure unit;
(e) Optionally cover the relief image film 131 with a protective film (not shown);
(f) Pull a vacuum in lower vacuum grooves 34 to remove air from under image film 131;
(g) Cast a layer of liquid photopolymer 43 adjacent to the relief image film 131;
(h) Place the clear substrate 150 in contact with the upper surface of the liquid photopolymer layer 43;
(i) Place the printed masking film 100 on top of the clear substrate 150;
(j) Lower the lid on the UV exposure unit and optionally pull a vacuum in upper vacuum grooves 28 to remove air from between upper glass 26, masking film 100, and substrate 150;
(k) Shine polymerizing radiation 52 through the masking film 100 for an amount of time suitable to form polymerized floor images 54 of a desired thickness in the liquid photopolymer;
(l) Shine polymerizing radiation 25 through the relief images 130 for an amount of time suitable to form polymerized relief images 210 in the liquid photopolymer between the polymerized floor images 54 and the relief images 130;
(m) Remove the above materials from the exposure unit;
(n) Remove the masking film 100 and the relief image film 131 from the materials; and
(o) Clean the polymerized material and substrate 150.

Figure 5 is a perspective illustration of the separated layers of a sheet of craft stamps produced after the exposure shown in Fig. 4 is fully cured and post-treated. This figure shows more clearly the images of the present invention and the method of making them. As before, the masking film 100 with its masking image 81, and the relief film 131 with its relief images 130, produce the polymeric stamp floor images 54 and stamp relief images 210 during exposure to UV light. As before, they are removed from the substrate 150 and the stamp relief images 210, respectively, and are discarded or reused. However, in accordance with the present invention, indexing images 400 have now been printed on the upper surface of the substrate 150. The inks used to produce the indexing images are solvent-based and may contain varying amounts of wavelength-specific light blockers and filters. In this invention the ink blocks light in the visible spectrum (390 to 700 nm wavelength) while being transparent or translucent to the shorter ultraviolet wavelengths. This allows UV light entering through the UV-transmitting areas 500 in the masking film 100 to create the same stamp floor images 210 unimpeded. The substrate 150 must be compatible with the solvent ink formula, namely polyvinylethylene, polyethylene, polyvinyl chloride, certain other vinyl-based polymers or polyester, but any ink-compatible film may be used within the scope of this invention without limitation.

In this description of the invention, inkjet printers are mentioned because they have been used by the inventor to generate the desired high-definition images with solvent-based inks. However, any printer capable of printing images of sufficient quality using solvent-based inks is within the scope of this invention without limitation.

## Claims

1. A craft stamp indexing image, **characterized in that** an actinic radiation-transmitting substrate (150) and ink are applied to the substrate, the ink being of the type that does not transmit visible wavelengths of light but does transmit radiation that cures photopolymers.

2. An image as claimed in claim1, **characterized in that** said ink is solvent-based; and
said substrate (150) is compatible with said ink.

3. An image as claimed in claim 1 and claim 2, **characterized in that** said substrate (150) comprises a plastic taken from the list of (a) vinyl-based plastic and (b) polyester.

4. An image as claimed in claim 3, **characterized in that** said vinyl-based plastic is taken from the list of: polyvinylethylene and polyvinyl chloride.

5. An image as claimed in any of claims 2 to claim 4, **characterized in that** said ink comprises visible light blockers.

6. An image as claimed in claim 5, **characterized in that** said visible wavelengths are between about 390 nm and 700 nm.

7. A method for making a craft stamp, **characterized in** the steps of:
(a) printing masking images (81) on a masking film (100);
(b) printing stamp relief images (130) on a relief image film (131);
(c) printing an indexing image (102, 104) on a compatible substrate (150);
(d) placing the relief image film (131) on the bottom glass (24) of a UV exposure unit;
(e) optionally covering the relief image film (131) with a protective film;
(f) optionally pulling a vacuum under the relief image film (131);
(g) casting a layer of liquid photopolymer (43) on top of the relief image film (131);
(h) placing the substrate (150) in contact with the upper surface of the liquid photopolymer layer (43);
(i) placing the masking film (100) on top of the substrate (150);
(j) lowering the lid on the UV exposure unit and optionally pulling a vacuum on the masking film (100) and substrate (150);
(k) shining polymerizing radiation through the masking film (100) for an amount of time suitable to form polymerized floor images (54) of a desired thickness in the liquid photopolymer (43);
(l) shining polymerizing radiation through the relief images (130) for an amount of time suitable to form polymerized relief images (130) in the liquid photopolymer (43) between the polymerized floor images (54) and the relief images (130);
(m) removing the above materials from the exposure unit;
(n) removing the masking film (100) and the relief image film (131) from the materials; and
(o) cleaning the polymerized material and substrate (150).

8. A method as claimed in claim 7, **characterized in that** step (c) is printing an indexing image (102) with an inkjet printer using a UV-transmitting and visible light-opaque ink on the substrate (150), the substrate (150) comprising vinyl-based polymeric material.

9. A method as claimed in claim 7 or claim 8, **characterized in that** step (c) is printing an indexing image (102) with an inkjet printer using a UV-transmitting and visible light-opaque ink on the substrate (150), the substrate (150) comprising polyvinylethylene.

10. A method as claimed in any of claims 7 to 9, **characterized in that** step (c) is printing an indexing image (102) with an inkjet printer using a UV-transmitting and visible light-opaque ink on the substrate (150), the substrate (150) comprising polyvinyl chloride.

11. A method as claimed in any of claims 7 to 10, **characterized in that** step (c) is printing an indexing image (102) with an inkjet printer using a UV-transmitting and visible light-opaque ink on the substrate (150), the substrate (150) comprising polyester.

12. A craft stamp indexing image, **characterized in** an actinic radiation-transmitting substrate (150) comprises solvent ink-printable polymers with ink applied to the substrate (150), the ink being solvent-based and opaque to visible wavelengths of light and able to transmit radiation that cures photopolymers (43).
